# EUROPÄISCHE PATENTSCHRIFT

(11) **EP 2 223 334 B1**
(45) Veröffentlichungstag und Bekanntmachung des Hinweises auf die Patenterteilung: **27.01.2016**
(21) Anmeldenummer: 08863100.7
(22) Anmeldetag: 11.11.2008
(51) Int. Cl.: H01L 23/40

(54) **KÜHLKÖRPER WENIGSTENS EINES ELEKTRISCHEN BAUTEILS**
COOLING BODY OF AT LEAST ONE ELECTRICAL COMPONENT
DISSIPATEUR THERMIQUE D'AU MOINS UN COMPOSANT ÉLECTRIQUE

(30) Priorität: 14.12.2007 DE 102007060249
(43) Veröffentlichungstag der Anmeldung: 01.09.2010
(73) Patentinhaber: Robert Bosch GmbH, 70442 Stuttgart (DE)
(72) Erfinder: WIRNITZER, Bernd, 71292 Friolzheim (DE); BREITENBACH, Jan, 70569 Stuttgart (DE); KYNAST, Andreas, 70176 Stuttgart (DE); SEIDEL, Thorsten, 71686 Remseck am Neckar (DE)
(86) Internationale Anmeldenummer: PCT/EP2008/065301
(87) Internationale Veröffentlichungsnummer: WO 2009/077268

(56) Entgegenhaltungen:
- FR-A- 2 780 456
- GB-A- 2 243 026
- US-A- 4 054 901
- US-A- 4 552 206
- US-A- 4 961 125
- US-A- 5 040 096
- US-A- 5 381 041
- US-A1- 2004 206 476
- US-A1- 2006 158 857

## Beschreibung

### Stand der Technik

Die Erfindung geht aus von einem Kühlkörper wenigstens eines elektrischen Bauteils nach dem Oberbegriff des Anspruchs 1.

Es ist bekannt, Kühlkörper an elektrische Leistungsbauteile zu montieren, um eine ausreichende Wärmeabfuhr aus dem Leistungsbauteil zu gewährleisten. Typischerweise bestehen solche Kühlkörper aus einer Fläche, die einen großflächigen Kontakt zum Leistungsbauteil herstellt und quer davon abstehenden Finnen, welche die Oberfläche des Kühlkörpers effektiv vergrößern und die Wärmeabfuhr verbessern. Häufig wird der Kühlkörper mit dem Leistungsbauteil durch eine Wärmeleitpaste oder eine Vergussmasse verbunden. Bei Vibrationen oder starken Beschleunigungsschwankungen kann es zu einer Beschädigung des Leistungsbauteils kommen.

Die US 2004/206476 A1 zeigt einen Kühlkörper, bei dem ein Bauteil zwischen zwei Schenkel eines ersten Kühlkörperabschnitts des Kühlkörpers geklemmt werden kann, indem der Kühlkörper von oben über das Bauteil geschoben wird. Der Kühlkörper wird mit einem Kontaktpin an einer Platine festgelötet, der sich hinter den Kontaktpins des Bauteils befindet. Seitlich abgewinkelte Kühlkörperabschnitte dienen als zusätzliche Kühlfläche und stehen auf der Platine auf.

### Offenbarung der Erfindung

Die Erfindung geht aus von einem Kühlkörper wenigstens eines elektrischen Bauteils.

Es wird vorgeschlagen, dass ein erster Kühlkörperabschnitt als Feder ausgebildet ist, wobei eine Kontaktfläche zwischen dem Kühlkörper und dem wenigstens einen Bauteil im ersten Kühlkörperabschnitt vorgesehen ist.

Der erste Kühlkörperabschnitt ist quer zu einem zweiten Kühlkörperabschnitt abgewinkelt, wobei der zweite Kühlköperabschnitt im montierten Zustand zur Befestigung des Kühlkörpers an einer Platine vorgesehen ist. Der erste Kühlkörperabschnitt kann gegen den zweiten Kühlkörperabschnitt flexibel bewegt werden. Vibrationen können einfach abgefedert werden. Weiterhin ist der erste Kühlkörperabschnitt bügelförmig mit einem ersten Schenkel und einem zweiten Schenkel ausgebildet. Durch die bügelförmige Ausgestaltung kann eine vorteilhafte Federwirkung des Kühlkörpers unterstützt werden. Durch die Ausgestaltung kann ein sicheres und zuverlässiges flächiges Anliegen des Kühlkörpers an dem wenigstens einem Bauteil und damit sowohl eine sichere Fixierung des wenigstens einen Bauteils als auch eine zuverlässige Wärmeabfuhr sichergestellt werden. Es kann eine zuverlässige Verbindung mit dem wenigstens einen Bauteil hergestellt werden und eine vorteilhafte kompakte und schmale Bauform des Kühlkörpers erreicht werden.

Vorteilhaft kann ein mit dem Kühlkörper am ersten Kühlkörperabschnitt verbundenes elektrisches Bauteil durch die Federwirkung des Kühlkörperabschnitts z.B. bei Vibrationen, Stoßeinwirkung oder Beschleunigungsschwankungen geschützt werden. So kann die Federwirkung des Kühlkörpers bei Deformationen z.B. nach starken Beschleunigungsschwankungen das elektrische Bauteil halten und wieder in die ursprüngliche Position zurückführen. Vorteilhaft kann der erste Kühlkörperabschnitt mit einem zweiten Kühlkörperabschnitt so verbunden sein, dass dieser erste Kühlkörperabschnitt z.B. federnd gegenüber dem zweiten Kühlkörperabschnitt auslenkbar ist. So kann der erste Kühlkörperabschnitt gegen den zweiten Kühlkörperabschnitt abgewinkelt oder mit einem Federelement verbunden sein. Ist der zweite Kühlkörperabschnitt starr fixiert, können Stöße oder Vibrationen durch den ersten Kühlkörperabschnitt abgefangen werden. Am Kühlkörper können auch mehrere zu kühlenden Bauteilen angeordnet sein, wobei wenigstens eines der Bauteile in der beschriebenen Weise mechanisch und hieraus resultierend thermisch angebunden ist.

Gemäß einer bevorzugten Weiterbildung kann der zweite Kühlkörperabschnitt mit wenigstens einem Befestigungselement im montierten Zustand an einer Platine befestigbar sein. Vorzugsweise kann die Platine festgeklemmt sein. Somit kann vorteilhaft z.B. eine Schraubverbindung, die zusätzliche Befestigungselemente benötigt und zeitaufwändig herzustellen ist, vermieden werden. Das wenigstens eine Befestigungselement kann bevorzugt als Raste oder als Crimpfuß ausgebildet sein und in entsprechende Aussparungen in der Platine eingreifen. Dadurch kann ein mechanischer Halt des Kühlkörpers auf der Platine ohne zusätzliche Befestigungselemente erreicht werden. Ein solider Zusammenhalt von Platine und Kühlkörper kann mit und ohne zusätzliche Vergussmasse erreicht werden. Die Befestigung kann jedoch auch so erfolgen, dass die Platine am Kühlkörperabschnitt einschiebbar ist. Eine Fixierung gegen ein Verschieben kann beispielsweise durch eine Vergussmasse, die z.B. über der Verbindungsstelle Platine/Kühlkörperabschnitt angeordnet ist, sichergestellt werden.

Vorteilhaft kann der erste Kühlkörperabschnitt am wenigstens einen Bauteil festklammerbar sein. Günstigerweise kann z.B. der erste Kühlkörperabschnitt zur Anlage an einer Hauptfläche des wenigstens einen Bauteils vorgesehen sein. Seitlich am Kühlkörperabschnitt können zwei Führungselemente ausgebildet sein, welche z.B. einander gegenüberliegende Seitenflächen des Bauteils fassen und z.B. der Führung des wenigstens einen Bauteils dienen.

Gemäß einer zweckmäßigen Ausgestaltung kann die Kontaktfläche an einer Innenseite wenigstens eines der Schenkel angeordnet sein. Dann kann das wenigstens eine Bauteil in einem Hohlraum zwischen den Schenkeln angeordnet sein. Vorteilhaft kann das wenigstens eine Bauteil dabei zwischen dem ersten und dem zweiten Schenkel klemmbar sein. Die Wärmeübertragung kann durch die Klemmkraft der beiden Schenkel sichergestellt werden, und das wenigstens eine Bauteil kann sicher fixiert sein. Denkbar ist auch, dass weitere elektrische Bauteile an einem oder beiden Schenkeln befestigt, z.B. angeschraubt, sind. So kann etwa das zwischen den Schenkeln angeordnete Bauteil ein Kondensator sein, während auf der Außenseite eines oder beider Schenkel andere Komponenten, etwa Feldeffekttransistoren, angeordnet sein können.

In einer alternativen Ausgestaltung kann die Kontaktfläche an einer Außenseite eines der Schenkel angeordnet sein. Die Wärmeübertragung kann durch eine Anpresskraft zwischen dem wenigstens einen Bauteil und Kühlkörper sichergestellt werden. Vorteilhaft kann im montierten Zustand das wenigstens eine Bauteil zwischen der Kontaktfläche an der Außenseite eines der Schenkel und einem weiteren Klemmabschnitt im Kühlkörper einklemmbar sein. Günstigerweise kann der Klemmabschnitt aus dem Kühlkörper gestanzt und passend umgebogen sein. Auch hier können weitere elektrische Bauteile an dem ersten Kühlköperabschnitt an dessen Außenseite angeordnet sein, z.B. an einer Außenseite angeschraubt sein.

Insgesamt lässt sich der Kühlkörper preiswert als Stanzteil herstellen, bei dem der erste Kühlkörperabschnitt, die Führungselemente, Klemmelement und Befestigungselemente in geeigneter Weise abgewinkelt werden können. Die Montage des Kühlkörpers bzw. des Bauteils kann schnell und kostengünstig erfolgen.

### Kurze Beschreibung der Zeichnungen

### Zeichnung

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen in schematischer Darstellung:
- Fig. 1 a, b: eine bevorzugte Ausgestaltung eines Kühlkörpers mit einem elektrischen Bauteil, das in einem Kühlkörperabschnitt festgeklemmt ist in perspektivischer (Fig. 1 a) und Seitenansicht (Fig. 1 c); und
- Fig. 2a, b: eine bevorzugte Ausgestaltung eines Kühlkörpers mit einem elektrischen Bauteil, das an einen Kühlkörperabschnitt angepresst ist in perspektivischer (Fig. 2a) und Seitenansicht (Fig. 2b).

### Ausführungsform der Erfindung

In den Figuren sind gleiche oder gleich wirkende Elemente mit denselben Bezugszeichen beziffert.

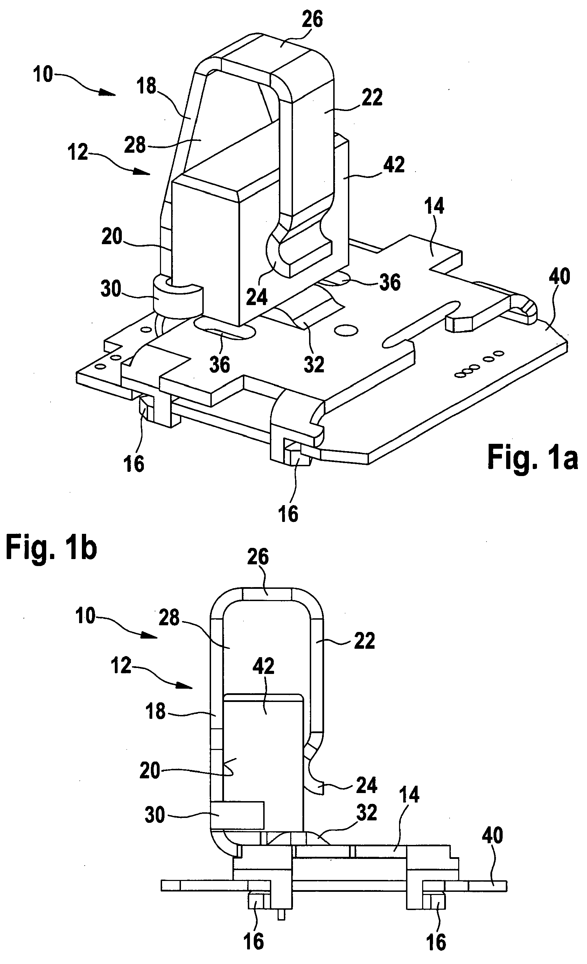

Den Fig. 1 a und 1 b ist eine erste bevorzugte Ausgestaltung eines Kühl körpers 10 in perspektivischer Ansicht (Fig.1a) bzw. Seitenansicht (Fig. 1 b) zu entnehmen. Ein auf einer Platine 40 montiertes elektrisches Bauteil 42 ist mit dem Kühlkörper 10 zur Wärmeabfuhr verbunden. Im abgebildeten Ausführungsbeispiel ist ein erster Kühlkörperabschnitt 12 als Feder ausgebildet, indem der erste Kühlkörperabschnitt 12 von einem zweiten Kühlkörperabschnitt 14 quer, insbesondere senkrecht, abgewinkelt ist. Der zweite Kühlkörperabschnitt 14 ist plattenförmig ausgebildet und an der Platine 40 mit Befestigungselementen 16 festgelegt.

Vorteilhaft kann die Befestigung des zweiten Kühlkörperabschnitts 14 an der Platine 40 mittels einer formschlüssigen Verbindung erfolgen, hier z.B. mit so genannten Crimpfüßen als Befestigungselementen 16, die in entsprechende, nicht näher bezeichnete Aussparungen der Platine 40 eingreifen. Die Platine 40 kann z.B. mit einem weiteren, nicht dargestellten Schaltkreis verbunden sein oder ein Ausschnitt aus einer größeren Platine sein.

Elektrische Kontakte des Bauteils 42 zur Platine 40 sind durch entsprechende Öffnungen 36 in dem zweiten Kühlkörperabschnitt 14 geführt. Das Bauteil 42 ist zur Wärmeabfuhr mechanisch mit dem ersten Kühlkörperabschnitt 12 verbunden. Das Bauteil 42 ist etwas von der Hauptfläche des zweiten Kühlkörperabschnitts 14 beabstandet und sitzt auf einem Höcker 32 des zweiten Kühlkörperabschnitts 14 auf.

Der erste Kühlkörperabschnitt 12 ist bügelförmig ausgebildet und weist einen ersten Schenkel 18 und einen dazu parallelen zweiten Schenkel 22 auf, die mit einem Verbindungsstück 26 verbunden sind. Eine Kontaktfläche 20 zwischen dem Kühlkörper 10 und dem Bauteil 42, welche die gezielt als Wärmeableitfläche dient, ist im ersten Kühlkörperabschnitt 12 vorgesehen.

Der erste Kühlkörperabschnitt 12 umfasst nicht näher bezeichnete Hauptflächen des Bauteils 42, wobei diese großflächig durch die Schenkel 18, 22 kontaktiert werden, indem die beiden Schenkel 18, 22 mit Klemmkraft das im Hohlraum 28 zwischen den Schenkeln 18, 22 angeordnete Bauteil 42 kontaktieren. Die Kontaktfläche 20 ist demgemäß an einer Innenseite des ersten Schenkels 18 angeordnet. Dort liegt der Schenkel 18 großflächig an dem Bauteil 42 an. Auf der gegenüberliegenden Seite liegt der zweite Schenkel 22 mit seinem gerundeten Endstück 24 an und drückt das Bauteil gegen den ersten Schenkel 18.

Das Bauteil 42 kann mittels Führungselementen 30 geführt und gegebenenfalls sogar gehalten werden, welche am Kühlkörperabschnitt 12 angeordnet sind und quer von diesem abstehen. Die Führungselemente 30 sind seitlich am ersten Schenkel 18 angeordnet, greifen an Seitenflächen des Bauteils 42 an und dienen der Führung des Bauteils 42.

Das Bauteil 42 kann z.B. ein Kondensator sein. Nicht dargestellt ist eine Variante, bei der weitere Bauteile, wie z.B. Feldeffekttransistoren, an der Außenseite des Schenkels 18 und/oder 22 des ersten Kühlkörperabschnitts 12 angeordnet, insbesondere angeschraubt, sein können.

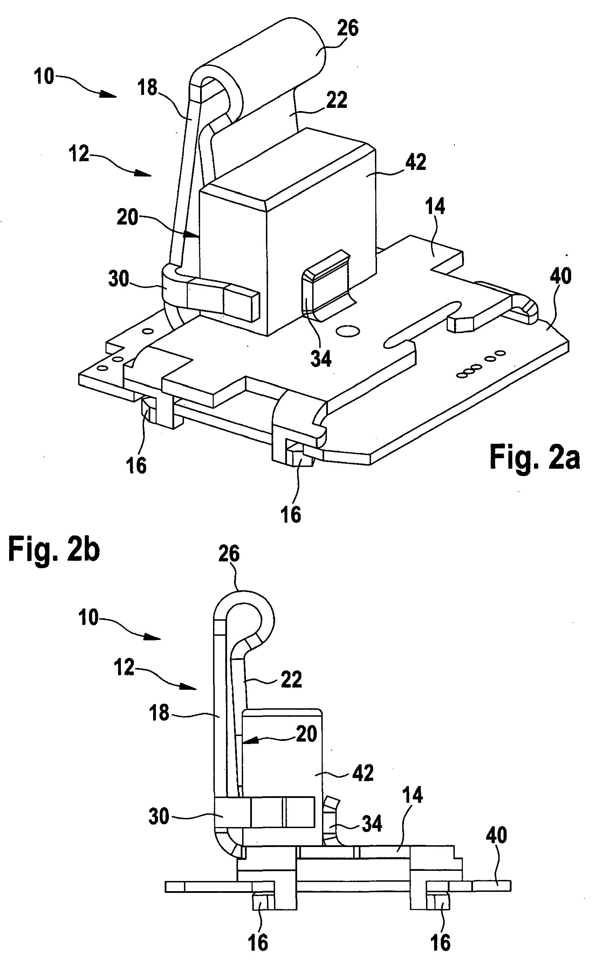

Fig. 2a und 2b zeigen eine alternative Ausgestaltung in perspektivischer Ansicht (Fig.2a) bzw. Seitenansicht (Fig. 2b), bei der eine zur gezielten Wärmeabfuhr gedachte Kontaktfläche 20 an einer Außenseite eines Schenkels 22 eines Kühlkörpers 10 angeordnet ist.

Ein auf einer Platine 40 montiertes elektrisches Bauteil 42 ist mit dem Kühlkörper 10 zur Wärmeabfuhr verbunden. Ein erster Kühlkörperabschnitt 12 ist als Feder ausgebildet, indem der erste Kühlkörperabschnitt 12 von einem zweiten Kühlkörperabschnitt 14 quer, insbesondere senkrecht, abgewinkelt ist. Der zweite Kühlkörperabschnitt 14 ist plattenförmig ausgebildet und an der Platine 40 mit Befestigungselementen 16 festgelegt.

Vorteilhaft kann die Befestigung des zweiten Kühlkörperabschnitts 14 an der Platine 40 mittels einer formschlüssigen Verbindung erfolgen, hier z.B. mit so genannten Crimpfüßen als Befestigungselementen 16, die in entsprechende, nicht näher bezeichnete Aussparungen der Platine 40 eingreifen. Die Platine 40 kann z.B. mit einem weiteren, nicht dargestellten Schaltkreis verbunden sein oder ein Ausschnitt aus einer größeren Platine sein.

Im dargestellten Ausführungsbeispiel ist im montierten Zustand das Bauteil 42 zwischen der Kontaktfläche 20 an der Außenseite eines der Schenkel 18, 22 und einem weiteren Klemmabschnitt 34 einklemmbar. Der Klemmabschnitt 34 kann aus dem zweiten Kühlkörperabschnitt 14 ausgestanzt und entsprechend gebogen sein.

Der erste Kühlkörperabschnitt 12 ist so ausgestaltet, dass die beiden Schenkel 18, 22 aneinander gepresst werden, wobei die Schenkel 18, 22 auseinander streben. Dadurch wird eine Federkraft gegen das Bauteil 42 ausgeübt, welcher der Klemmabschnitt 34 entgegenwirkt und so das Bauteil 42 fest gegen die Außenseite des zweiten Schenkels 22 presst. Durch den innigen flächigen Kontakt kann ein guter Wärmeübergang vom Bauteil 42 in den Schenkel 22 und damit in den Kühlkörperabschnitt 12 erfolgen.

Das Bauteil 42 ist auch hier am ersten Kühlkörperabschnitt 12 mittels Führungselementen 30 gehalten bzw. geführt. Die Führungselemente 30 sind seitlich am ersten Schenkel 18 angeordnet, quer zu diesem abgewinkelt und greifen an Seitenflächen des Bauteils 42 an.

Das Bauteil 42 kann z.B. ein Kondensator sein. Nicht dargestellt ist eine Variante, bei der weitere Bauteile, wie z.B. Feldeffekttransistoren, an der Außenseite des Schenkels 18 und/oder 22 des ersten Kühlkörperabschnitts 12 angeordnet, insbesondere angeschraubt, sein können.

## Patentansprüche

1. Kühlkörper (10) wenigstens eines elektrischen Bauteils (42), wobei ein erster Kühlkörperabschnitt (12) als Feder ausgebildet ist, wo- wobei bei eine Kontaktfläche (20) zwischen dem Kühlkörper (10) und dem wenigstens einen Bauteil (42) am ersten Kühlkörperabschnitt (12) vorgesehen ist,
- wobei der erste Kühlkörperabschnitt (12) quer zu einem zweiten Kühlkörperabschnitt (14) abgewinkelt ist,
- der erste Kühlkörperabschnitt (12) bügelförmig mit einem ersten Schenkel (18) und einem zweiten Schenkel (22) ausgebildet ist und
- wobei der erste Kühlkörperabschnitt (12) mit dem zweiten Kühlkörperabschnitt (14) so verbunden ist, dass der erste Kühlkörperabschnitt (12) federnd gegenüber dem zweiten Kühlkörperabschnitt (14) auslenkbar ist, **dadurch gekennzeichnet, dass** der zweite Kühlkörperabschnitt im montierten Zustand zur Befestigung des Kühlkörpers (10) an einer Platine (40) vorgesehen ist.

2. Kühlkörper nach Anspruch 1, **dadurch gekennzeichnet, dass** der zweite Kühlkörperabschnitt (14) mit wenigstens einem Befestigungselement (16) im montierten Zustand an einer Platine (40) festklemmbar ist.

3. Kühlkörper nach Anspruch 2, **dadurch gekennzeichnet, dass** das wenigstens eine Befestigungselement (16) als Crimpfuß ausgebildet ist.

4. Kühlkörper nach einem der vorhergehenden Ansprüche, **dadurch gekennzeichnet, dass** der erste Kühlkörperabschnitt (12) Führungselemente (30) zum Führen des wenigstens einen Bauteils (42) aufweist.

5. Kühlkörper nach einem der vorhergehenden Ansprüche, **dadurch gekennzeichnet, dass** die Kontaktfläche (20) an einer Innenseite wenigstens eines der Schenkel (18, 22) angeordnet ist.

6. Kühlkörper nach Anspruch 5, **dadurch gekennzeichnet, dass** das wenigstens eine Bauteil (42) zwischen dem ersten und dem zweiten Schenkel (18, 22) klemmbar ist.

7. Kühlkörper nach einem der Ansprüche 1 bis 4, **dadurch gekennzeichnet, dass** die Kontaktfläche (20) an einer Außenseite eines der Schenkel (18, 22) angeordnet ist.

8. Kühlkörper nach Anspruch 6, **dadurch gekennzeichnet, dass** im montierten Zustand das wenigstens eine Bauteil (42) zwischen der Kontaktfläche (20) an der Außenseite eines der Schenkel (18, 22) und einem Klemmabschnitt (34) einklemmbar ist.

9. Kühlkörper nach einem der vorhergehenden Ansprüche, **dadurch gekennzeichnet, dass** an einer oder mehreren Außenseiten des ersten Kühlkörperabschnitts (12) ein oder mehrere weitere elektrische Bauteile angeordnet sind.

## Claims

1. Heat sink (10) of at least one electrical component (42), wherein a first heat sink section (12) is in the form of a spring, wherein a contact area (20) is provided between the heat sink (10) and the at least one component (42) at the first heat sink section (12),
- wherein the first heat sink section (12) is angled transversely in relation to a second heat sink section (14),
- the first heat sink section (12) is designed in the form of a clip with a first limb (18) and a second limb (22), and
- wherein the first heat sink section (12) is connected to the second heat sink section (14) such that the first heat sink section (12) can be deflected with a spring action in relation to the second heat sink section (14), **characterized in that** the second heat sink section is provided for fastening the heat sink (10) to a printed circuit (40) in the mounted state.

2. Heat sink according to Claim 1, **characterized in that** the second heat sink section (14) can be firmly clamped to a printed circuit (40) by way of at least one fastening element (16) in the mounted state.

3. Heat sink according to Claim 2, **characterized in that** the at least one fastening element (16) is in the form of a crimping foot.

4. Heat sink according to one of the preceding claims, **characterized in that** the first heat sink section (12) has guide elements (30) for guiding the at least one component (42).

5. Heat sink according to one of the preceding claims, **characterized in that** the contact area (20) is arranged on an inner face of at least one of the limbs (18, 22).

6. Heat sink according to Claim 5, **characterized in that** the at least one component (42) can be clamped between the first and the second limb (18, 22).

7. Heat sink according to one of Claims 1 to 4, **characterized in that** the contact area (20) is arranged on an outer face of one of the limbs (18, 22).

8. Heat sink according to Claim 6, **characterized in that** the at least one component (42) can be clamped between the contact area (20) on the outer face of one of the limbs (18, 22) and a clamping section (34) in the mounted state.

9. Heat sink according to one of the preceding claims, **characterized in that** one or more further electrical components are arranged on one or more outer faces of the first heat sink section (12).

## Revendications

1. Dissipateur thermique (10) d'au moins un composant électrique (42), une première partie (12) du dissipateur thermique étant réalisée sous forme de ressort, une surface de contact (20) entre le dissipateur thermique (10) et l'au moins un composant (42) étant prévue sur la première partie (12) du dissipateur thermique,
- la première partie (12) du dissipateur thermique étant coudée transversalement à une deuxième partie (14) du dissipateur thermique,
- la première partie (12) du dissipateur thermique étant réalisée en forme d'étrier avec une première branche (18) et une deuxième branche (22) et
- la première partie (12) du dissipateur thermique étant connectée à la deuxième partie (14) du dissipateur thermique de telle sorte que la première partie (12) du dissipateur thermique puisse être déviée élastiquement par rapport à la deuxième partie (14) du dissipateur thermique,
**caractérisé en ce que** la deuxième partie du dissipateur thermique, dans l'état monté, est prévue pour fixer le dissipateur thermique (10) à une platine (40).

2. Dissipateur thermique selon la revendication 1, **caractérisé en ce que** la deuxième partie (14) du dissipateur thermique peut être serrée fixement à une platine (40) par au moins un élément de fixation (16) dans l'état monté.

3. Dissipateur thermique selon la revendication 2, **caractérisé en ce que** l'au moins un élément de fixation (16) est réalisé sous forme de base de sertissage.

4. Dissipateur thermique selon l'une quelconque des revendications précédentes, **caractérisé en ce que** la première partie (12) du dissipateur thermique présente des éléments de guidage (30) pour guider l'au moins un composant (42).

5. Dissipateur thermique selon l'une quelconque des revendications précédentes, **caractérisé en ce que** la surface de contact (20) est disposée au niveau d'un côté interne d'au moins l'une des branches (18, 22).

6. Dissipateur thermique selon la revendication 5, **caractérisé en ce que** l'au moins un composant (42) peut être serré entre la première et la deuxième branche (18, 22).

7. Dissipateur thermique selon l'une quelconque des revendications 1 à 4, **caractérisé en ce que** la surface de contact (20) est disposée au niveau d'un côté extérieur de l'une des branches (18, 22).

8. Dissipateur thermique selon la revendication 6, **caractérisé en ce que** dans l'état monté, l'au moins un composant (42) peut être serré entre la surface de contact (20) au niveau du côté extérieur de l'une des branches (18, 22) et une partie de serrage (34).

9. Dissipateur thermique selon l'une quelconque des revendications précédentes, **caractérisé en ce qu'**un ou plusieurs composants électriques supplémentaires sont disposés au niveau d'un ou plusieurs côtés extérieurs de la première partie (12) du dissipateur thermique.
